Europäisches Patentamt

European Patent Office

Office européen des brevets

(11) Numéro de publication : **0 572 289 A1**

(19)

# (12) DEMANDE DE BREVET EUROPEEN

(21) Numéro de dépôt : **93401000.0**

(51) Int. Cl.⁵ : **H05K 3/00**, G06F 15/60

(22) Date de dépôt : **16.04.93**

(30) Priorité : **24.04.92 FR 9205061**

(43) Date de publication de la demande :
**01.12.93 Bulletin 93/48**

(84) Etats contractants désignés :
**BE DE GB IT NL**

(71) Demandeur : **SEXTANT AVIONIQUE**
**5,7, rue Jeanne Braconnier Parc Tertiaire**
**F-92360 Meudon-la-Forêt (FR)**

(72) Inventeur : **Charruau, Stéphane**
**THOMSON-CSF, SCPI, BP 329**
**F-92402 Courbevoie Cedex (FR)**

(74) Mandataire : **Benoit, Monique et al**
**THOMSON-CSF SCPI B.P. 329 50, rue**
**Jean-Pierre Timbaud**
**F-92402 Courbevoie Cédex (FR)**

(54) **Ordonnancement de tronçons de lignes d'un réseau, notamment pour le calcul de diaphonies entre lignes d'un réseau électrique.**

(57) L'invention concerne un ordonnancement de tronçons de lignes d'un réseau.

Des tronçons de lignes pouvant être en interaction entre eux, un rang principal est attribué à chaque tronçon, les rangs principaux étant incrémentés de telle façon que des tronçons en interaction entre eux aient des rangs principaux dont l'écart est au plus égal à l'unité et que tous les tronçons d'une même ligne aient le même rang.

Application : Calcul de diaphonies entre lignes d'un réseau électrique.

FIG.5

Jouve, 18, rue Saint-Denis, 75001 PARIS

L'invention concerne un ordonnancement de tronçons de lignes d'un réseau. Elle s'applique notamment à la détermination par calcul de diaphonies entre tronçons de lignes de réseaux électriques particulièrement denses, où il est nécessaire de simplifier la structure de matrices mises en jeu, en les rapprochant le plus possible de matrices diagonales par exemple.

Plus généralement, l'invention s'applique à l'ordonnancement de tronçons de lignes de réseaux quelconques pour lesquels il est demandé de déterminer des interactions entre ces lignes.

L'augmentation de la puissance de calcul des ordinateurs et des micro-ordinateurs a été rendue possible grâce à l'émergence et à la maturation de la technologie des circuits intégrés complexes, tels les microprocesseurs dédiés à des usages généraux de, traitement numérique de l'information ou à des usages spécifiques délicats tels la génération d'images synthétiques en trois dimensions par exemple.

Cependant, l'évolution de la technologie des circuits intégrés complexes, notés VLSI selon la terminologie anglo-saxonne "Very Large Scale Integration", a induit des contraintes de conception drastiques sur les substrats supports d'interconnexions tels que les circuits imprimés ou les céramiques à films minces par exemple. Ces contraintes se traduisent concrètement par le recours à des conducteurs imprimés et des isolements diélectriques de plus en plus fins sur les substrats d'interconnexion de manière à limiter raisonnablement l'épaisseur des circuits imprimés. Par ailleurs, à l'augmentation de la finesse des conducteurs et à l'amincissement des isolements diélectriques, s'est combinée la montée en fréquence de fonctionnement des microprocesseurs, atteignant par exemple 50 MHz.

La combinaison des évolutions précitées conduit notamment au risque de déformation des signaux électriques et de création de signaux parasites par suite de diaphonie entre plusieurs conducteurs ayant certaines portions très proches les unes des autres. Il devient donc nécessaire, dès la conception des circuits imprimés ou des substrats d'interconnexion, de prévoir l'existence de diaphonie ou de parasitages entre lignes. En effet, ces circuits étant organisés en réseaux très denses, il n'est souvent plus possible de les corriger, une fois réalisés, en cours de mise au point.

Des simulations numériques existent pour prévoir ces parasitages. A partir de l'excitation électrique d'une ligne d'un réseau par exemple, le résultat de la simulation indique la génération de courants et tensions produits sur les autres lignes du réseau. Néanmoins, devant tenir compte de la propagation des parasites par diaphonie de proche en proche sur des lignes de plus en plus éloignées des lignes perturbatrices initialement ou par réflexions multiples, ces simulations font appel à de nombreuses séquences de calcul, coûteuses en temps d'occupation d'unités centrales d'ordinateurs ainsi qu'en place de mémoire. Cet inconvénient est notamment dû au fait que ces simulations font intervenir des calculs matriciels où des matrices de rang très élevé, dont la valeurs optimale est très difficile à déterminer à priori en fonction des diaphonies physiquement significatives, doivent être inversées.

Un autre inconvénient provient du fait que, les lignes du réseau étant découpées en tronçons définis par les contraintes de définition automatique des conducteurs, le découpage ainsi obtenu n'est jamais optimisé pour l'analyse des diaphonies et ne permet pas la résolution efficace du problème de la propagation des perturbations incidentes et réfléchies.

Le but de l'invention est de pallier les inconvénients précités, notamment en découpant les lignes du réseau en tronçons puis en créant un ordonnancement de ces derniers permettant le rapprochement de la structure des matrices de résolution de celle de matrices diagonales, ce qui permet de réduire les temps de calcul et la place mémoire nécessaires aux moyens de simulation numériques.

A cet effet, l'invention a pour objet un ordonnancement de tronçons de lignes d'un réseau, des tronçons pouvant être en interaction entre eux, caractérisé en ce qu'un rang principal est attribué à chaque tronçon, les rangs principaux étant incrémentés de telle façon que des tronçons en interaction entre eux aient des rangs principaux dont l'écart est au plus égal à l'unité et que tous les tronçons d'une même ligne aient le même rang, le rang d'origine étant attribué aux tronçons d'une ligne dont au moins un tronçon est en interaction avec un tronçon d'une autre ligne.

Outre les avantages précités, l'invention a pour principaux avantages qu'elle permet aux moyens de simulation de s'intégrer facilement dans une chaîne de conception assistée par ordinateur et qu'elle améliore la détermination de phénomènes de parasitage entre lignes d'un réseau.

D'autres caractéristiques et avantages de l'invention apparaîtront à l'aide de la description qui suit, faite en regard des dessins annexés qui représentent :
- la figure 1, une vue de dessus d'un réseau de lignes ;
- la figure 2, un découpage possible de lignes en tronçons ;
- les figures 3, 4 et 5, des exemples d'ordonnancement de tronçons de lignes selon l'invention.

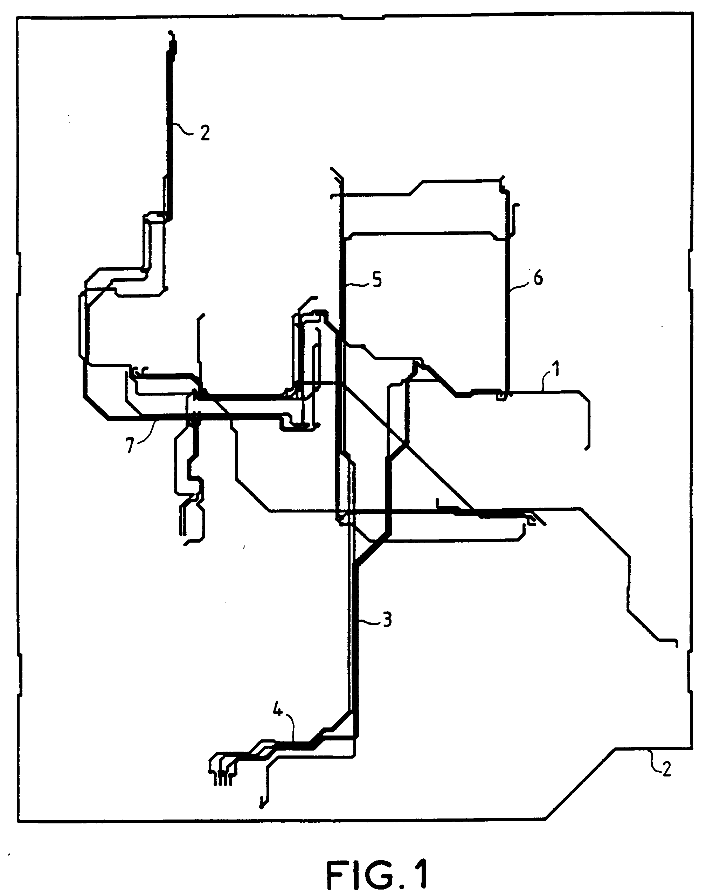

La figure 1 présente une vue de dessus d'un réseau de lignes 1. Ce peut être par exemple le réseau de conducteurs d'un circuit imprimé multicouche ou d'un substrat d'interconnexions 2. Les lignes représentées semblent se superposer et se croiser car elles sont en fait sur plusieurs niveaux différents. Dans le cas de conducteurs électriques, ces niveaux sont séparés par des matériaux isolants, diélectriques notamment. Des groupes 2, 3, 4, 5, 6, 7 de portions de lignes très rapprochées créent des zones où des phénomènes de diaphonie risquent notamment de se produire. Pour déterminer ces phénomènes, il est possible par exemple d'activer une ligne et d'observer les courants et tensions induits dans les autres lignes. Cette activation est réalisée en fait par simulation. Dans le cas de lignes électriques, cette simulation utilise notamment les équations de l'électromagnétisme de Maxwell. Selon des méthodes connues, les lignes sont à cet effet découpées en tronçons élémentaires. Les tronçons sont définis par exemple de telle sorte que la résolution des équations soit mise en oeuvre par découplage d'une coordonnée d'espace des deux autres et aboutisse à un calcul matriciel élémentaire c'est à dire par tronçon. Ainsi, si $I_{ns}$ et $V_{ns}$ représentent les valeurs du courant et de la tension à la sortie d'un tronçon "isolé" c'est à dire n'étant pas le siège d'un phénomène de diaphonie et $I_{ne}$ et $V_{ne}$ la valeur du courant et de la tension à l'entrée de ce tronçon, $I_{ns}$ et $V_{ns}$ peuvent par exemple s'obtenir à partir de $I_{ne}$ et $V_{ne}$ par un calcul matriciel élémentaire défini par la relation suivante :

$$\begin{pmatrix} I_{ns} \\ V_{ns} \end{pmatrix} = (T) \begin{pmatrix} I_{ne} \\ V_{ne} \end{pmatrix} \qquad (1)$$

où (T) représente une matrice carrée d'ordre 2 fonction de la longueur du tronçon et du temps, obtenue par la résolution des équations de Maxwell appliquées au tronçon de ligne.

Lorsque le tronçon est le siège d'un phénomène de diaphonie, $I_{ns}$ et $V_{ns}$ sont aussi fonction de courants et tensions de tronçons de lignes voisins. Cette influence se détermine encore par un calcul matriciel, défini par exemple par la relation suivante écrite dans le domaine fréquEnciel :

$$\begin{pmatrix} I_{ns} \\ V_{ns} \end{pmatrix} = \sum_{K} (T_k) \begin{pmatrix} I_{ke} \\ V_{ke} \end{pmatrix} \qquad (2)$$

où $I_{ke}$ et $V_{ke}$ représentent par exemple le courant et la tension à l'entrée d'un tronçon de ligne voisine du tronçon de référence et en diaphonie avec lui et $(T_k)$ une matrice carrée d'ordre 2, $\sum_{K}$ étant l'opérateur de sommation des produits matriciels relatifs à chaque tronçon en diaphonie avec le tronçon de référence..

Le courant et la tension à chaque extrémité d'un tronçon donné s'obtiennent par concaténation de relations telles que (2), écrites pour tous les tronçons de toutes les lignes objet de diaphonies directes ou indirectes avec la ligne portant le tronçon choisi en premier lieu.

Cette concaténation aboutit en définition à une relation matricielle dans le domaine fréquenciel telle que :

$$(A) (X) = (B) \qquad (3)$$

où (X) est un vecteur inconnu, (B) un vecteur connu, (A) une grande matrice carrée connue.

La simulation, pour être efficace, doit prévoir les courants et tensions aux extrémités de chaque tronçon. En conséquence, cette simulation nécessite la résolution d'un calcul matriciel global où la matrice de transfert globale est constituée des matrices élémentaires précédemment définies < Les réseaux de lignes à traiter étant de plus en plus complexes, donc les tronçons plus nombreux, il en résulte que cette matrice globale a un ordre très élevé pouvant atteindre plusieurs milliers par exemple. Une telle matrice est coûteuse en place de mémoire et entraîne de longs temps de calcul de transformation de Fourier inverse ou de produits de convolution par exemple. Or, pour chaque tronçon donné, celui-ci est en interaction ou situation de diaphonie avec seulement un nombre limité d'autres tronçons, d'où il résulte que de nombreux éléments de la matrice globale de résolution sont nuls. En l'absence d'ordonnancement particulier des tronçons dans la constitution de la matrice, les éléments non nuls de celle-ci sont répartis de façon quelconque.

L'ordonnancement des tronçons proposés par l'invention permet de regrouper les éléments non nuls de la matrice globale, notamment autour de sa diagonale.

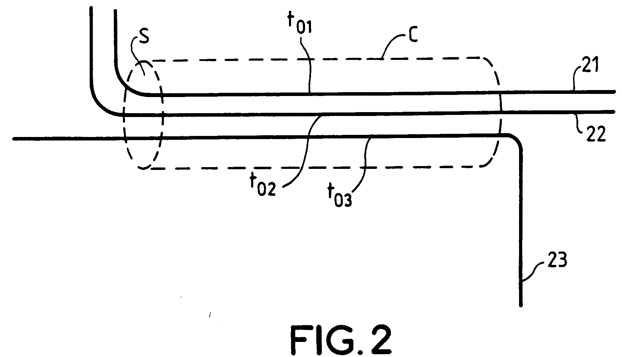

La figure 2, définit un découpage possible de tronçons de lignes, notamment dans le cas de lignes électriques, d'autres types de découpage étant bien sûr possibles.

Un rayon d'influence décrivant une courbe fermée, un cercle par exemple, à l'intérieur de laquelle des éléments de lignes sont supposés se parasiter mutuellement, par création de diaphonie par exemple, est préalablement défini. La courbe fermée délimite une section S qui peut être la base d'un cylindre C. Les parties de lignes 21, 22, 23 intérieures à ce cylindre C définissent des tronçons $t_{01}$, $t_{02}$, $t_{03}$. Les tronçons intérieurs au cylindre sont supposés être en interaction. Dans le cas de conducteurs électriques, il est préférable de définir la longueur du cylindre de telle façon que sur toute cette longueur, les tronçons de ligne $t_{01}$, $t_{02}$, $t_{03}$ soient parallèles. En effet, il est plus aisé de résoudre les équations de l'électromagnétisme quand les éléments de ligne, ici les tronçons $t_{01}$, $t_{02}$, $t_{03}$, sont parallèles. Il est aussi préférable de donner au cylindre C la plus grande longueur possible. A cet effet, une extrémité du cylindre C est définie par exemple par une de ses sections droites où au moins une des parties de ligne constituant ses tronçons intérieurs devient non parallèle aux autres. Le cylindre C peut par exemple être centré sur un de ses tronçons. Les dimensions de la section S dont les tronçons qui le traversent sont supposés en interaction peuvent par exemple être définis suivant la nature des conducteurs ou des diélectriques et suivant les fréquences de fonctionnement, dans le cas notamment de réseaux de conducteurs. En général, la section S du cylindre C est très petite devant la longueur de ce dernier. Pour un réseau de lignes donné, une section d'influence S étant donnée, les lignes du réseau sont découpées en tronçons obtenus conformément aux tronçons $t_{01}$, $t_{02}$, $t_{03}$ de la figure 2. Si les tronçons d'un même cylindre sont préférentiellement parallèles, ils ne sont pas obligatoirement rectilignes.

L'exemple de découpage précédemment déterminé est réalisé de telle façon qu'un tronçon est une partie de ligne contenue dans un cylindre de section droite donnée S, les tronçons d'un même cylindre étant préférentiellement parallèles entre eux. La longueur de chaque cylindre est définie de telle façon qu'il contient au moins un tronçon prolongé par un autre tronçon non parallèle. quand une partie de ligne n'est pas en interaction avec d'autres parties de lignes, c'est à dire quand il n'existe pas au moins une autre partie de ligne avec laquelle elle puisse être contenue dans un cylindre de section donnée S, cette partie de ligne constitue le tronçon unique d'un tel cylindre. Si ce tronçon n'est pas directement soumis à une interaction, du type diaphonie par exemple, il peut néanmoins être parcouru par des courants parasites si d'autres tronçons de sa ligne sont en interaction avec d'autres tronçons. A chacun des tronçons ainsi défini sont appliqués des calculs matriciels du type des relations (1) et (2) précédemment établies.

Selon l'invention, un premier ordonnancement de ces tronçons, simplifiant la matrice globale de résolution, du type de la matrice (A) de la relation (3) par exemple, attribue à chaque tronçon un rang principal, noté r, les rangs principaux étant incrémentés de telle façon que des tronçons en interaction, ou d'un même cylindre dans le cas du découpage précédent, aient des rangs principaux dont l'écart est au plus égal à l'unité et que tous les tronçons d'une même ligne aient le même rang principal. Ainsi, un rang r étant le rang inférieur des tronçons d'un même cylindre, tous les tronçons de ce cylindre ont le rang r ou le rang r+1 égal au rang r augmenté d'une unité. Le rang 0 d'origine est attribué aux tronçons d'une ligne dont au moins un tronçon est en interaction, ou contenu dans un même cylindre, avec un tronçon d'une autre ligne. Mis à part cette condition, la ligne dont les tronçons ont le rang d'origine peut être choisie arbitrairement. Une ligne n'ayant aucun tronçon en interaction peut préférentiellement être mise à l'écart de l'ordonnancement, sa prise en compte dans le calcul matriciel de la simulation étant indifférent vis à vis des autres lignes.

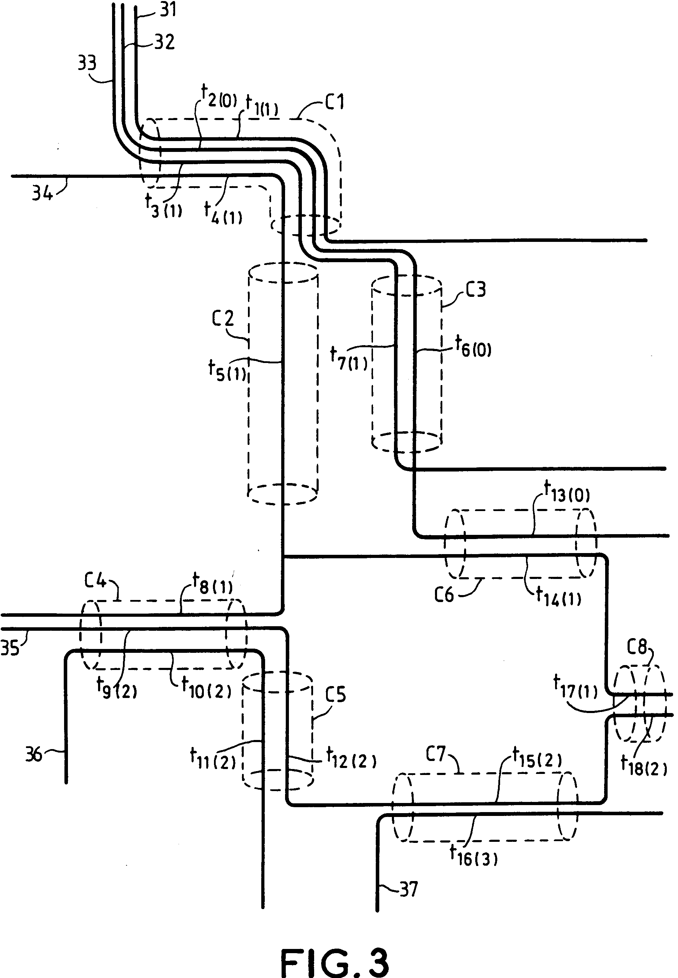

La figure 3 présente un exemple d'ordonnancement de tronçons selon l'invention. Des lignes 31, 32, 33, 34, 35, 36, 37 ont des tronçons en interaction. Pour des raisons de clarté, tous les cylindres du découpage n'ont pas été représentés ; seulement huit d'entre eux, C1, C2, C3, C4, C5, C6, C7, C8 ont été représentés. Un premier cylindre C1 comprend quatre tronçons $t_1$, $t_2$, $t_3$, $t_4$ appartenant à quatre lignes 31, 32, 33, 34. Le rang principal 0 est par exemple attribué au tronçon $t_2$ de la ligne 32. Pour faciliter la compréhension de l'ordonnancement selon l'invention, les rangs principaux sont indiqués à côté des repères des tronçons ; ces rangs sont notés entre parenthèses. Les autres tronçons $t_1$, $t_3$, $t_4$ du cylindre C1 ont alors un rang principal égal à 1. Le deuxième cylindre C2 ne comprend qu'un seul tronçon $t_5$ appartenant à la ligne 34 qui possède un tronçon de rang 1, son rang principal est donc aussi égal à 1. Le troisième cylindre C3 comprendra deux tronçons $t_6$, $t_7$ dont l'un $t_6$ appartient à la ligne 32 et a donc un rang principal égal à 0 et l'autre $t_7$ appartient à la ligne 33 et a donc un rang principal égal à 1. Le quatrième cylindre C4 comprend trois tronçons dont l'un $t_5$ appartient à la ligne 34 et a donc un rang égal à 1, les deux autres tronçons $t_9$, $t_{10}$ appartenant à des lignes 35, 36 ont un rang égal à 2. Un cinquième cylindre C5 comprend deux tronçons $t_{11}$, $t_{12}$ appartenant respectivement aux lignes 35, 36 qui ont chacune un tronçon de rang principal égal à 2. Ces deux tronçons $t_{11}$, $t_{12}$ ont donc aussi un rang principal égal à 2. Un sixième cylindre C6 comprend deux tronçons $t_{13}$, $t_{14}$ dont les lignes 32, 34 ont respectivement des tronçons égaux à 0 et à 1. Ces numéros de rang sont donc respectivement attribués à $t_{13}$ et $t_{14}$. Un septième cylindre C7 comprend deux tronçons $t_{15}$, $t_{16}$. Le premier $t_{15}$ appartient à une ligne 35 dont les tronçons ont un rang principal égal à 2 adopte ce rang alors que le deuxième $t_{16}$ adopte un rang principal égal à 3. Un huitième cylindre C8 comprend deux tronçons $t_{17}$, $t_{18}$, le premier $t_{17}$ a un rang principal égal à 1 et le deuxième a un rang principal égal à 2 comme les autres tronçons de leurs lignes respectives.

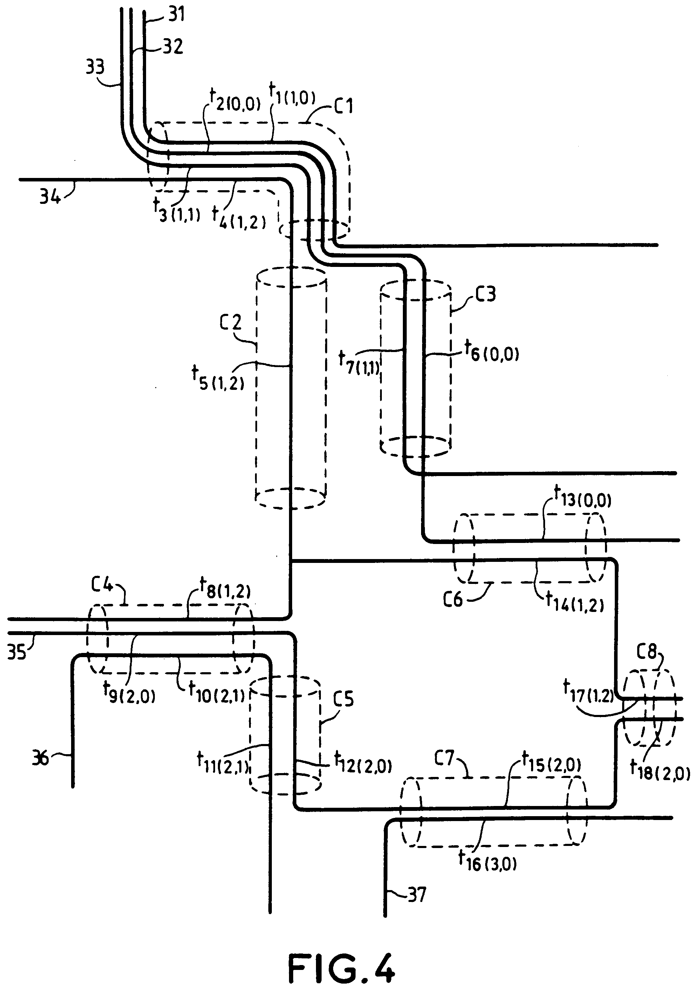

En appliquant l'ordonnancement selon l'invention, une matrice globale de simulation est donc constituée de tronçons ordonnés suivant leur rang principal. Dans le cas des tronçons de la figure 3 par exemple, la matrice globale peut être constituée de façon à s'appliquer à un vecteur colonne dont les composantes, correspondant à des excitations électriques par exemple, sont ordonnées du haut vers le bas de la même façon que les tronçons de la figure 4, le tronçon $t_2(0)$ étant suivi respectivement des tronçons $t_6(0)$, $t_{13}(0)$, $t_1(1)$, $t_3(1)$, $t_4(1)$, $t_5(1)$, $t_7(1)$, $t_5(1)$, $t_{14}(1)$, $t_{17}(1)$, $t_9(2)$, $t_{10}(2)$, $t_{11}(2)$, $t_{12}(2)$, $t_{15}(2)$, $t_{18}(2)$, $t_{16}(3)$.

L'avantage de cet ordonnancement selon l'invention est que, pour une ligne ou une colonne donnée de la matrice, les éléments non nuls ne vont pas au delà des lignes ou des colonnes correspondant à des tronçons de rang immédiatement supérieur, r+1, ou immédiatement inférieur, r-1 au rang r du tronçon associé à la ligne ou à la colonne. Cela rapproche les éléments non nuls de la diagonale de la matrice puisque ses lignes et ses colonnes sont classées en fonction des rangs principaux des tronçons qui leurs sont associés.

Pour améliorer l'ordonnancement selon l'invention, un ordonnancement secondaire et un ordonnancement tertiaire peuvent être créés selon l'invention pour ordonner les tronçons ayant même rang principal. A cet effet, pour un rang principal donné, le rang secondaire d'un tronçon correspond au rang de sa ligne parmi les lignes dont les tronçons ont ce même rang principal donné, les lignes ayant des rangs distincts et successifs, et le rang d'origine 0 étant attribué à une ligne quelconque parmi celles-ci.

La figure 4 illustre cet ordonnancement selon l'invention par rangs secondaires. Les tronçons et les cylindres représentés sont les mêmes que ceux de la figure 3. Dans le premier cylindre C1, le tronçon $t_2$ de rang principal égal a 0 à un rang secondaire égal à 0, la ligne 32 étant la seule à posséder des tronçons de rang principal égal à 0. Les lignes 31, 33, 34 des trois autres tronçons $t_1$, $t_3$, $t_4$ de rang principal égal à 1 ont par exemple des rangs égaux respectivement à 0, 1 et 2, ces rangs étant les rangs secondaires de leurs tronçons. Pour faciliter la compréhension du classement selon l'invention, sur la figure 4, les repères des tronçons sont suivis d'un couple dont la première composante indique le rang principal et la seconde composante indique le rang secondaire.

Le tronçon $t_5$ du deuxième cylindre C2 appartient à une ligne 34 de rang 2 parmi les lignes de tronçons de rang principal égal à 1, le rang secondaire du tronçon $t_5$ est donc égal à 2. De même les deux tronçons $t_6$, $t_7$ du troisième cylindre C3 ont respectivement les rangs secondaires 0 à 1, ainsi que le tronçon $t_8$ de rang principal 1 du quatrième cylindre C4. Les deux autres tronçons $t_9$, $t_{10}$ du quatrième cylindre C4 ayant un rang principal égal à 2, l'un $t_9$ a par exemple le rang secondaire 0 et l'autre $t_{10}$ a par exemple le rang secondaire 1. En conséquence les deux tronçons $t_{11}$, $t_{12}$ du cinquième cylindre C5 ont par exemple les rangs secondaires respectifs 1 et 0. Les deux tronçons $t_{13}$ et $t_{14}$ du sixième cylindre C6 ont les rangs secondaires respectifs 0 et 2, $t_{14}$ appartenant à la ligne 34 de rang 2 parmi les lignes dont les tronçons ont le rang principal 1. Les deux tronçons $t_{15}$, $t_{16}$ du septième cylindre C7 ont des rangs secondaires égaux à 0, le tronçon $t_{16}$ de rang principal 3 étant seul à avoir ce rang. Enfin, les deux tronçons $t_{17}$, $t_{18}$ du huitième cylindre C8 ont respectivement les rangs secondaires 2 et 0.

Ainsi, les tronçons du vecteur colonne précités peuvent être ordonnés selon l'invention en fonction de leur rang principal et de leur rang secondaire. Dans le cas des tronçons de ligne de la figure 4, le vecteur colonne a ses composantes ordonnées par exemple de la même façon que les tronçons, le tronçon $t_2(0,0)$ étant suivi respectivement des tronçons $t_6(0,0)$, $t_{13}(0,0)$, $t_1(1,0)$, $t_3(1, 1)$, $t_7(1, 1)$, $t_4(1,2)$, $t_5(1,2)$, $t_8(1,2)$, $t_{14}(1,2)$, $t_{17}(1,2)$, $t_9(2,0)$, $t_{12}(2,0)$, $t_{15}(2,0)$, $t_{18}(2,0)$, $t_{10}(2,1)$, $t_{11}(2, 1)$, $t_{16}(3,0)$.

Le rang tertiaire proposé par l'invention permet d'ordonner entre eux les tronçons ayant même rang principal et même rang secondaire. Ce rang tertiaire ordonne les tronçons d'une même ligne, des tronçons successifs ayant préférentiellement des rangs tertiaires successifs.

Ce rang tertiaire peut correspondre en fait à un rang de cylindre sur une même ligne, le rang tertiaire d'un tronçon étant alors le rang de son cylindre.

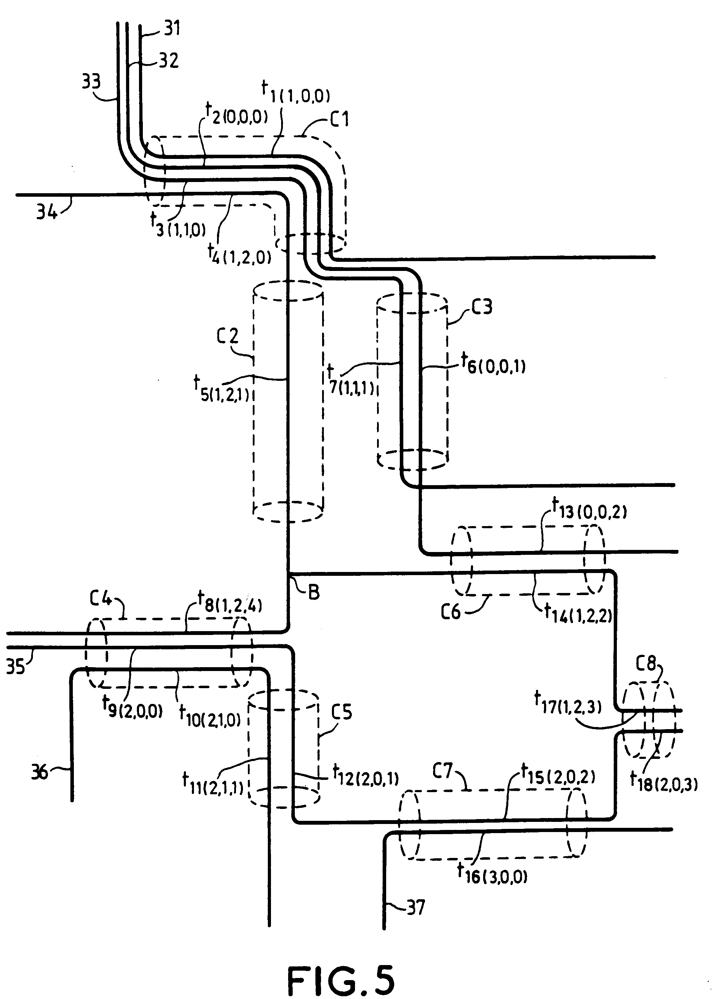

La figure 5 illustre l'ordonnancement selon l'invention, les tronçons étant ordonnés en fonction de leur rang principal, puis à l'intérieur de celui-ci en fonction de leur rang secondaire, puis à l'intérieur de ce dernier en fonction de leur rang tertiaire. Pour faciliter la compréhension de l'ordonnancement selon l'invention, sur la figure 5, les repères des tronçons sont suivis d'un triplet où la première composante représente le rang principal, la deuxième composante le rang secondaire et la troisième composante le rang tertiaire du tronçon. Pour des raisons de clarté, les tronçons dont les cylindres n'ont pas été représentés n'ont pas été pris en compte dans cet ordonnancement.

Les tronçons de la figure 5 sont les mêmes que ceux des figures 3 et 4 et ont notamment mêmes rangs principaux et secondaires que ceux de la figure 4. Les tronçons du premier cylindre C1 ont par exemple tous un rang tertiaire égal à 0, le rang tertiaire origine 0 étant attribué à ces tronçons par rapport aux autres tronçons de leurs lignes respectives, Le tronçon $t_5$ du deuxième cylindre C2 a alors le rang tertiaire 1 ainsi que les deux tronçons $t_6$, $t_7$ du troisième cylindre C3, les deux tronçons $t_{13}$, $t_{14}$ du sixième cylindre ayant le rang tertiaire 2. Les deux tronçons du huitième cylindre C8 ont le rang tertiaire 3. La ligne 34 ayant un point de bifurcation B, son tronçon $t_8$ contenu dans le quatrième cylindre a le rang tertiaire suivant celui du tronçon $t_{17}$ de mêmes rangs principal et secondaire contenu dans le huitième cylindre C8, ce tronçon $t_8$ a donc le rang tertiaire 4.

Il est possible à partir d'une bifurcation, telle que la bifurcation B de la ligne 34, de considérer les bifurcations comme étant des lignes nouvelles, dont les tronçons auraient des rangs principaux et secondaires différents par rapport aux autres tronçons d'avant la bifurcation.

Les deux autres tronçons du quatrième cylindre C4 ont le même rang tertiaire égal à 0. Les deux tronçons $t_{11}$, $t_{12}$ du cinquième cylindre ont le rang tertiaire suivant, c'est à dire égal à 1. Enfin, le tronçon $t_{16}$ du septième cylindre C7 de rang principal égal à 3 a un rang tertiaire égal à 0 alors que l'autre tronçon $t_{15}$ de ce cylindre C7, venant après le tronçon $t_{12}$ de rang

tertiaire 1, a un rang tertiaire égal à 2.

Selon l'invention, les tronçons de la figure 5 peuvent être finalement ordonnés à partir du tronçon $t_2$, l'ordonnancement étant le suivant :

$t_2(0,0,0)$
$t_6(0,0,1)$
$t_{13}(0,0,2)$
$t_1(1,0,0)$
$t_3(1,1,0)$
$t_7(1,1,1)$
$t_4(1,2,0)$
$t_5(1,2,1)$
$t_{14}(1,2,2)$
$t_{17}(1,2,3)$
$t_8(1,2,4)$
$t_9(2,0,0)$
$t_{12}(2,0,1)$
$t_{15}(2,0,2)$
$t_{18}(2,0,3)$
$t_{10}(2,1,0)$
$t_{11}(2,1,1)$
$t_{16}(3,0,0)$

Dans un cas d'application de simulation pour estimer des phénomènes de diaphonies entre lignes, par exemple, la matrice de calcul peut être définie de telle façon que les éléments de chacune de ses lignes s'appliquent à des tronçons ordonnés suivant l'invention, et que les lignes soient ordonnées de façon à obtenir un vecteur réponse dont les composantes ont le même ordonnancement que leurs tronçons associés, et ordonnés selon l'invention.

Ainsi, dans l'exemple de découpage des figures 3, 4, 5, la matrice de calcul peut être constituée en fonction de l'ordonnancement des composantes du vecteur d'entrée correspondant à l'ordonnancement précédemment établi, puisque chaque composantes du vecteur d'entrée représente par exemple une excitation électrique d'un tronçon donné.

Les constitutions de matrices globales réalisées par la déposante, notamment obtenues à partir des équations de Maxwell dans le cas de lignes électriques de circuits imprimés ou de substrats d'interconnexions par exemple, ont montré qu'en ordonnant les colonnes et les lignes de la matrice conformément à l'ordonnancement selon l'invention appliqué aux tronçons auxquels elles étaient associées, la matrice globale a ses éléments proches de sa diagonale. L'ordre de ces matrices étant généralement très élevé, cet ordonnancement des tronçons de lignes d'un réseau économise grandement de la place en mémoire et réduit de façon très significative la durée des temps de calcul nécessaire par exemple à des simulations.

L'ordonnancement selon l'invention peut être appliqué à tous types de réseaux dont des tronçons de lignes sont en interaction entre eux et dès qu'une simulation est nécessaire pour prévoir leur comportement, notamment en phase de conception.

**Revendications**

1. Ordonnancement de tronçons de lignes d'un réseau, des tronçons pouvant être en interaction entre eux, caractérisé en ce qu'un rang principal est attribué à chaque tronçon, les rangs principaux étant incrémentés de telle façon que des tronçons en interaction entre eux aient des rangs principaux dont l'écart est au plus égal à l'unité et que tous les tronçons d'une même ligne aient le même rang, le rang d'origine étant attribué aux tronçons d'une ligne dont au moins un tronçon est en interaction avec un tronçon d'une autre ligne.

2. Ordonnancement selon la revendication 1, caractérisé en ce que chaque tronçon possède en outre un rang secondaire correspondant au rang de sa ligne parmi les lignes ' dont les tronçons ont le même rang principal, les lignes ayant des rangs distincts et successifs.

3. Ordonnancement selon l'une quelconque des revendications précédentes, caractérisé en ce que chaque tronçon possède en outre un rang tertiaire définissant son rang parmi les autres tronçons d'une même ligne.

4. Ordonnancement selon la revendication 3, caractérisé en ce que deux tronçons successifs d'une même ligne ont des rangs tertiaires successifs.

5. Ordonnancement selon l'une quelconque des revendications 2 à 4, caractérisé en ce que les tronçons sont ordonnés en fonction de leur rang secondaire parmi les tronçons de même rang principal.

6. Ordonnancement selon l'une quelconque des revendications 3 à 5, caractérisé en ce que les tronçons sont ordonnés en fonction de leur rang tertiaire parmi les tronçons de même rang principal et de même rang secondaire.

7. Ordonnancement selon l'une quelconque des revendications précédentes, caractérisé en ce qu'une section (S) étant donnée, des tronçons $(t_{01}, t_{02}, t_{03})$ contenus dans un même cylindre (C) dont la section droite est égale à la section donnée sont en interaction.

8. Ordonnancement selon la revendication 7, caractérisé en ce qu'un tronçon $(t_{01}, t_{02}, t_{03})$ est déterminé par une partie de ligne (21, 22, 23) contenue dans un cylindre (C) dont tous les tronçons sont sensiblement parallèles entre eux, un tronçon étant parallèle à lui-même, le cylindre ayant sa section droite égale à la section (S) donnée.

**9.** Ordonnancement selon la revendication 7, caractérisé en ce qu'un au moins ($t_{03}$) des tronçons d'un même cylindre (C) est prolongé par un tronçon non parallèle à ce tronçon ($t_{03}$) en sortie du cylindre.

**10.** Ordonnancement selon l'une quelconque des revendications 7 à 9, caractérisé en ce qu'un cylindre (C) est centré sur un tronçon ($t_{02}$).

**11.** Ordonnancement selon l'une quelconque des revendications précédentes, caractérisé en ce que les lignes sont des conducteurs électriques.

FIG.1

FIG. 2

FIG.3

# FIG.4

FIG.5

**Office européen des brevets**

# RAPPORT DE RECHERCHE EUROPEENNE

Numero de la demande

EP   93 40 1000

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | PROCEEDINGS OF THE VLSI AND COMPUTER PERIPHERALS CONFERENCE 8 Mai 1989, HAMBURG pages 5.82 - 5.85 DYCK ET AL. 'LISIM - A SIMULATOR FOR TIME DOMAIN SIMULATION OF LOSSY TRANSMISSION LINE SYSTEMS IN A NON LINEAR CIRCUIT ENVIRONMENT' * page 5.83, alinéa 3.1; figure 1 * | 1 | H05K3/00 G06F15/60 |
| A | NTT REVIEW vol. 1, no. 4, Novembre 1989, TOKYO JP pages 122 - 128 MATSUI ET AL. 'ELECTRICAL SIMULATORS FOR HIGH-SPEED PRINTED CIRCUITS BOARDS' * le document en entier * | 1 | |
| A | PRINTED CIRCUIT DESIGN vol. 9, no. 2, Février 1992, NEW-YORK pages 11 - 17 SMITH ET AL. 'SIMULATING HIGH-SPEED SYSTEMS' * figure 9 * | 1 | |
| A | MIKROWELLEN & HF MAGAZIN vol. 16, no. 8, Décembre 1990, pages 517 - 521 SUNDERMANN ET AL. 'SIMULATION VON ÜBERSPRECH- UND REFLEKTIONSVORGÄNGEN AUF LEITERPLATTEN' * le document en entier * | 1 | |
| A | IBM TECHNICAL DISCLOSURE BULLETIN. vol. 30, no. 6, Novembre 1987, NEW YORK US pages 346 - 348 'EFFICIENT WIRING TO AVOID "CROSSTALK" PROBLEMS IN ELECTRONIC CIRCUITRY' * le document en entier * | 1 | |

**DOMAINES TECHNIQUES RECHERCHES (Int. Cl.5)**

H05K
G06F
H04B

Le présent rapport a été établi pour toutes les revendications

| Lieu de la recherche | Date d'achèvement de la recherche | Examinateur |
|---|---|---|
| LA HAYE | 05 AOUT 1993 | LINA F. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)